# EUROPEAN PATENT SPECIFICATION

(11) **EP 2 484 803 B1**
(45) Date of publication and mention of the grant of the patent: **29.03.2017**
(21) Application number: 11305115.5
(22) Date of filing: 07.02.2011
(51) Int. Cl.: C23C 16/40, C23C 16/455, H01L 21/02, H01L 31/02, H01L 31/0216, H01L 31/18

(54) **Method of deposition of Al2O3/SiO2 stacks, from aluminium and silicon precursors**
Verfahren zum Aufsetzen von Al2O3/SiO2-Stapeln, von Aluminium- und Silikonvorläufern
Procédé pour le dépôt de piles d'Al2O3/SiO2 de précurseurs du silicium et de l'aluminium

(43) Date of publication of application: 08.08.2012
(73) Proprietor: L'AIR LIQUIDE, SOCIETE ANONYME POUR L'ETUDE ET L'EXPLOITATION DES PROCEDES GEORGES CLAUDE, 75007 Paris (FR); Technische Universiteit Eindhoven, 5612 AZ Eindhoven (NL)
(72) Inventor: Lachaud, Christophe, 91240, SAINT-MICHEL SUR ORGE (FR); Madec, Alain, 91140, VILLEBON S/YVETTE (FR); Kessels, Wilhelmus Mathijs Marie, 5045 ZZ, TILBURG (NL); Dingemans, Gijs, 5021 VX, TILBURG (NL)
(74) Representative: Grout de Beaufort, François-Xavier

(56) References cited:
- EP-A2- 1 860 690
- WO-A1-2009/002892
- WO-A2-2006/097525
- WO-A2-2008/014492
- US-A1- 2005 112 282
- US-A1- 2006 216 548
- US-A1- 2009 203 227

## Description

The present invention concerns a method of deposition of Al₂O₃/SiO₂ and Si₃N₄/Al₂O₃/SiO₂ stacks, from aluminium and silicon precursors, useful for the deposition of thin films in photovoltaic technologies, in particular for solar cells.

The photovoltaic effect is known since the end of the 19^{th} century. The principle consists in converting light energy into electricity. In the current context where shortages in fossil energy are expected by the end of the century, this is a promising solution to produce clean and renewable energy. One of the reasons for the slow development of photovoltaic electricity up to now is its lack of competitiveness compared to the traditional solutions such as coal, fossil fuels or nuclear based electricity. So the contribution of solar electricity as one significant component of the future energy mix is bounded to the capability to reduce further the cost per watt peak. To reach this goal, reduction of the manufacturing costs and improvement of cell's efficiency are two solutions that must be explored in parallel.

Reduction of the manufacturing costs is addressed for example with thinner wafers usage to limit the impact of silicon price on the overall cell's cost and in general with reduced raw materials consumption, including chemicals used during each step of the manufacturing. This manufacturing cost decrease is often driven by manufacturing tools providers (the OEM - Original Equipment Manufacturers) and by material suppliers.

Improvement of photovoltaic cell's efficiency requires innovation often driven by R&D laboratories. For example, there is significant R&D work carried out by academics on passivation phenomenon. This may contribute to the enhancement of the photovoltaic cell's performance.

SiO₂ is known in semiconductor and photovoltaic industries to be a passivation material leading to a strong reduction in surface recombination. High quality SiO₂ layer is grown by wet thermal oxidation at 900°C or dry oxidation at 850°C-1000°C under oxygen. These high temperatures are generally not compatible with photovoltaic devices manufacturing. Therefore, alternative methods were developed such as Chemical Vapor Deposition of SiO₂ from TEOS (Tetraethoxysilane) with O₂. But one of the drawbacks of CVD is the difficulty to control the thickness and consequently the resulting inhomogeneity of the film. Another disadvantage is the relatively poor passivation of CVD SiO₂. For these reasons Atomic Layer Deposition (ALD) is preferred as it allows achieving deposition of homogeneous layer, showing good passivation properties.

Whatever the deposition method, activation of the passivation capabilities of an as-deposited SiO₂ layer, an annealing step must be performed under hydrogen at 850°C. If this annealing step is not carried out under hydrogen, structural defect will be reduced but the surface recombination velocity (SRV) will not decrease as massive hydrogen activation and consequently hydrogen diffusion is required to achieve significant dangling bonds passivation at the surface of silicon. This hydrogen can of course come from the film itself but the hydrogen is mainly supplied by the N₂-H₂ atmosphere. If the annealing temperature is over 900°C a loss of hydrogen from the surface can happen and therefore be detrimental to the passivation properties of the silicon oxide layer. Also, even though this phenomenon is reversible thanks to another annealing, a natural loss of hydrogen can happen and induce a decrease of the SRV with time and therefore harm the passivation capabilities of the layer.

The conversion efficiency of a device is increased if the probability of hole-electron pairs to recombine at the surface or in the bulk of the silicon is reduced: the lower the number of defects into the material the higher the probability that charge carriers are collected. The recombination takes place on the front side of the solar cell as well as on the backside. In fact, hydrogen radicals are integrated into the film during deposition. The annealing step is performed under a nitrogen atmosphere with an appropriate hydrogen concentration to obtain a more pronounced driving force for the hydrogen to passivate the dandling bond. A hydrogen desorption phenomenon is increased with the annealing temperature but it is also observed at room temperature: it explains the decrease of the SiO₂ layer's passivation properties. Hydrogen is therefore a key player and its chemical passivation capability is known.

SiO₂ has passivation capabilities but, due to the drawbacks discussed above, Al₂O₃ passivation is now considered. As for SiO₂ layers, recent studies of Al₂O₃ deposition demonstrate that the layer is naturally enriched with hydrogen during deposition. Al₂O₃ contains a reasonable level of hydrogen and therefore it is not strictly necessary to add H₂ to the N₂.

As for SiO₂, hydrogen in the layer will chemically passivate the dangling bonds at the surface of the interface and in the bulk of the silicon. Contrary to SiO₂, no hydrogen desorption is observed and therefore one can believe that the efficiency of the chemical passivation will not decrease with time. Consequently, Al₂O₃ capability to perform passivation can be higher than the SiO₂ one.

So there is a need for a layer having a very efficient passivation for n-type and p-type substrates.

The present invention concerns a method of forming an Al₂O₃/SiO₂ stack comprising successively the steps of:
a) providing a substrate into a reaction chamber;
b) injecting into the reaction chamber, through an ALD process, at least one silicon containing compound selected from the group consisting of:
   BDEAS Bis(diethylamino)silane

      SiH₂(NEt₂)₂,
   BDMAS Bis(dimethylamino)silane

      SiH₂(NMe₂)₂,
   BEMAS Bis(ethylmethylamino)silane

      SiH₂(NEtMe)₂,
   DIPAS (Di-isopropylamido)silane

      SiH₃(NiPr₂),
   DTBAS (Di tert-butylamido)silane

      SiH₃(NtBu₂);
c) injecting into the reaction chamber an oxygen source selected in the list:
   oxygen, ozone, oxygen plasma, water, CO₂ plasma, N₂O plasma;
d) reacting at a temperature comprised between 20°C and 400°C, preferably lower or equal to 250°C, into the reaction chamber at least one of the silicon containing compounds and the oxygen source in order to obtain the SiO₂ layer deposited onto the substrate;
e) injecting on said silicon oxide film, through an ALD process, at least one aluminum containing compound selected in the list: Al(Me)₂(NMe)₂ or Al(Me)₂(NEt)₂;
f) injecting the oxygen source as defined in step c);
g) reacting at a temperature comprised between 20°C and 400°C, preferably lower or equal to 250°C, into the reaction chamber at least one of the aluminium containing compounds and the oxygen source in order to obtain the Al₂O₃ layer deposited onto the SiO₂ layer issued of step d).

According to other embodiments, the invention concerns:
A method as defined above wherein said silicon containing compound is BDEAS Bis(diethylamino)silane SiH₂(NEt₂)₂.
A method as defined above, comprising the steps:
   - Repeating steps b) to d) before the beginning of step e) until the desired SiO₂ layer thickness is obtained; and if necessary,
   - Repeating steps e) to g) until the desired Al₂O₃ layer thickness is obtained.
A method as defined above, wherein SiO₂ layer has a thickness comprised between 1 nm and 15nm and Al₂O₃ layer has a thickness of 30nm.
A method as defined above, comprising the step:
   h) annealing the Al₂O₃/SiO₂ stack issued of step g) at a temperature comprised between 400°C and 900°C, preferably between 400°C and 425°C, in an atmosphere of nitrogen.
A method as defined above, wherein the duration of the annealing step h) is no more than 10 minutes.

In the present invention, the as-deposited SiO₂ layer has high hydrogen content: the higher the amount of hydrogen in the silicon precursor the higher the content of hydrogen in the layer. Al₂O₃ is used as a diffusion barrier for hydrogen and to transfer the hydrogen radicals from the alumina layer to the SiO₂ layer during the annealing step. Thanks to the presence of the Al₂O₃ layer, the hydrogen atoms in the SiO₂ are also better confined. In this case, the annealing step can be performed without hydrogen. Moreover, the thickness of the SiO₂ layer is used to reduce the field effect passivation of Al₂O₃ that is not appropriate for n-type substrate. So, the stack is a good solution for an efficient passivation of n-type substrates and can be used for p-type substrates as well without significant increase in the surface recombination velocity.

Nevertheless, a very efficient stack results from the usage of the most appropriate combination of precursors.

The inventors of the present invention found that the precursors used in the method of the invention provide an appropriately high hydrogen concentration in the layers to feed a chemical equilibrium which effectively transfers hydrogen to the Si interface to passivate the dangling bonds. Moreover, another advantage of the invention is the use of the same oxidizer for the two precursors (during steps c) and f)) allowing an easier industrial usage.

The inventors have found that this combination of precursors will lead to a hydrogen-rich Al₂O₃/SiO₂/Si stack with a low level of metallic contamination. Thanks to this level of hydrogen, the stack has good chemical passivation capabilities. Another benefit of the invention is the usage of an ALD method, allowing a precise control of the SiO₂ and Al₂O₃ layers' thicknesses: It is clearly an advantage to be able to grow a layer with a homogeneous thickness whatever the roughness of the substrate.

Those skilled in the art will recognize that this novel combination of precursors is not solely limited to the deposition of a back surface passivation stack for multi-crystalline and monocrystalline silicon wafer based photovoltaic solar cell but its benefit could be applied to other various applications where a passivation layer is used.

### Detail of a method for Al₂O₃/ SiO₂ stacks deposition:

1. In one embodiment of the invention, the vaporization of the aluminum and silicon precursors can be performed by introducing a gas in the two canisters containing for the first the said aluminium containing compound according to the present invention molecules and for the second canister the said silicon. The canisters are preferably heated at a temperature which allows to vaporize the said source with a sufficient vapor pressure. The carrier gas can be selected, from Ar, He, H₂, N₂ or mixtures of them. The canisters can for instance be heated at temperatures in the range of 20°C to 170°C. The temperature can be adjusted to control the amount of precursor in the gas phase.
2. In another embodiment of the invention, the said aluminium containing compound according to the present inventionis fed in the liquid state to a vaporizer where it is vaporized.
3. In another embodiment of the invention, the said silicon containing compound according to the present inventionis fed in the liquid state to a vaporizer where it is vaporized.
4. In another embodiment, only one of the two precursors is fed in the liquid state to a vaporizer where it is vaporized.
5. In one embodiment of the invention, the pressure in said canisters is in the range from 0,133 Pa to 133 kPa.
6. The said vaporized silicon source is introduced into a reaction chamber where it is contacted to a substrate. The substrate can be selected from the group consisting of Si, SiO₂, SiN, SiON, and other silicon containing substrates and films and even other metal containing films. The substrate can be heated to sufficient temperature to obtain the desired film at sufficient growth rate and with desired physical state and composition. Typical temperature range from 50°C to 400°C. Preferably the temperature is lower or equal to 250°C. The pressure in the reaction chamber is controlled to obtain the desired metal containing film at sufficient growth rate. The pressure typically ranges from 0,133 Pa to 133 kPa or higher.
7. The said vaporized aluminum source is introduced into a reaction chamber where it is contacted to a substrate with a SiO₂ layer on the surface. The substrate can be heated to sufficient temperature to obtain the desired film at sufficient growth rate and with desired physical state and composition. The temperature typically ranges from 50°C to 400°C. Preferably the temperature is lower or equal to 250°C. The pressure in the reaction chamber is controlled to obtain the desired metal containing film at sufficient growth rate. The pressure typically ranges from 0,133 Pa to 133 kPa or higher.
8. In one embodiment of the invention, the said aluminium containing compound according to the present invention described in 1 are mixed to one or more reactant species prior to the reaction chamber.
9. In one embodiment of the invention, the said silicon containing compound according to the present inventiondescribed in 1 is mixed to one or more reactant species in the reaction chamber.
10. In another embodiment of the invention, for the deposition of the SiO₂ layer, the said silicon containing compound according to the present inventionsource and the reactant species are introduced sequentially in the reaction chamber (atomic layer deposition) or different combinations. One example is to introduce the reactant species (one example could be oxygen) continuously and to introduce silicon containing compound according to the present inventionsource by pulse.
11. In another embodiment of the invention, for the deposition of the SiO₂ layer, the said silicon containing compound according to the present inventionsource and the reactant species are introduced simultaneously (or continuously) in the reaction chamber at different spatial positions. The substrate is moved to the different spatial positions in the reaction chamber to be contacted by the precursor or the reactant species (spatial-ALD).
12. In another embodiment of the invention, for the deposition of the Al₂O₃ layer, the said aluminium containing compound according to the present inventiondescribed in 1 and the reactant species are introduced sequentially in the reaction chamber (atomic layer deposition) or different combinations. One example is to introduce the reactant species (one example could be oxygen) continuously and to introduce the said aluminium containing compound according to the present invention by pulse.
13. In another embodiment of the invention, for the deposition of the Al₂O₃ layer, the said aluminium containing compound according to the present inventiondescribed in 1 and the reactant species are introduced simultaneously (or continuously) in the reaction chamber at different spatial positions. The substrate is moved to the different spatial positions in the reaction chamber to be contacted by the precursor or the reactant species (spatial-ALD).
14. In one embodiment of the invention, for the deposition of the SiO₂ and/or Al₂O₃ layer, the reactant species can be flown through a remote plasma system localized upstream of the reaction chamber, and decomposed into radicals.
15. In one embodiment of the invention the said reactant species include an oxygen source which is selected from oxygen (O₂), oxygen radicals (for instance O· or OH·) for instance generated by a remote plasma, ozone (O₃), moisture (H₂O) and H₂O₂, CO₂ plasma, N₂O plasma, oxygen plasma.
16. In one embodiment of the invention, the said aluminium containing compound according to the present invention described in 1 are used for atomic layer deposition of Al₂O₃ films. One of the said aluminum sources and the reactant species are introduced sequentially in the reaction chamber (atomic layer deposition). The reactor pressure is selected in the range from 0,133 Pa to 133 kPa. Preferably, the reactor pressure is comprised between 1,333 kPa and 13,3 kPa. A purge gas is introduced between the metal source pulse and the reactant species pulse. The purge gas can be selected from the group consisting of N_{2,} Ar, He. The aluminum source, purge gas and reactant species pulse duration is comprised between 0.001 s and 10 s. Preferably, the pulse duration is comprised between 5 ms and 50 ms.
17. In another embodiment of the invention, the said silicon containing compound according to the present invention is used for atomic layer deposition of SiO₂ films. One of the said silicon sources or a mixture of them and the reactant species are introduced sequentially in the reaction chamber (atomic layer deposition). The reactor pressure in selected in the range from 0,133 Pa to 133 kPa. Preferably, the reactor pressure is comprised between 1,333 kPa and 13,3 kPa. A purge gas in introduced between the metal source pulse and the reactant species pulse. The purge gas can be selected from the group consisting of N₂, Ar, He. The silicon source, purge gas and reactant species pulse duration is comprised between 0.1 s and 100s. Preferably the pulse duration is comprised between 0.5 s and 10s.
   In one embodiment, the SiO₂ layer is deposited first and then an Al₂O₃ capping layer is deposited. If necessary a new bilayer Al₂O₃/SiO₂ can be deposited. The deposition of the bilayer can be repeated several times if necessary.
18. In one embodiment of the invention, the deposition method described in 18 can be used for aluminium silicate film deposition.
19. In another embodiment of the invention, a Si₃N₄ capping layer can be deposited from the said silicon containing compound according to the present invention source by ALD on the Al₂O₃/SiO₂ stack deposited with the method described in the points 1 to 18. This triple stack can be used for applications such as front side passivation of solar cells.
20. In one embodiment of the invention, the passivation properties of the layer are activated with an annealing step in a range of temperature between 350°C to 1000°C. Preferably, the annealing is carried out between 400°C and 600°C.

### EXAMPLES

### Deposition of a bilayer Al₂O₃lSiO₂ on Si from H₂Si(NEt₂) and Al(CH₃)₃.

The SiO₂ layer is deposited on an n-type silicon substrate by PEALD. Oxygen plasma is used as a reactant in combination with H₂Si(NEt₂)₂. The silicon precursor is stored in a stainless steel canister heated at 50°C. The precursor is vapor drawn. The substrate temperature is regulated at 150°C. The precursor is first introduced into the reactor (50 ms pulse). Oxygen is introduced continuously in the reactor as well as argon (this silicon precursor does not react with oxygen). After a 2 s purge sequence, a plasma is activated for 4 s. This sequence is followed by a new 2 s purge sequence. The pressure in the reactor is ∼0,2 Pa.

These conditions are compatible with a self-limited 1.1 Å/cycle growth.

The Al₂O₃ layer is deposited on the previously deposited SiO₂ layer from trimethylaluminum (TMA) and oxygen plasma. TMA has a high vapor pressure and therefore the vapor is drawn into the reactor. The precursor is introduced into the reactor with a 10 ms duration pulse. Oxygen is introduced continuously in the reactor as well as argon. A first 10 ms TMA pulse is introduced into the reactor followed by a 2 s purge sequence. A plasma is then activated for 4 s and followed by a new 2 s purge sequence. A growth rate of 1 Å/cycle is achieved.

Several types of stacks are deposited on several substrates. SiO₂ layers have a thickness between 1 nm and 15 nm. The Al₂O₃ layer thickness remains the same (∼30 nm). The stack is then annealed at 400°C in an atmosphere of nitrogen. The duration of this annealing step is only 10 min. The surface recombination varies between 1 and 10 cm/s for this thickness range.

From this example, we can prove that the use of TMA and SiH₂(NEt₂)₂, processed with the same oxidizer, for the deposition of a Al₂O₃/SiO₂ stack leads to a very efficient passivation.

This type of combination can be easily used in ALD equipments such as standard ALD reactor or in-line spatial ALD reactor.

### Deposition of a triple stack system Si₃N₄/Al₂O₃/SiO₂ on Si from H₂Si(NEt₂)₂ and Al(CH₃)₃.

The SiO₂ layer is deposited on a n-type silicon substrate by PEALD. Oxygen plasma is used as a reactant in combination with H₂Si(NEt₂)₂. The silicon precursor is stored in a stainless steel canister heated at 40°C. The carrier gas is argon. The substrate temperature is regulated at 150°C. The precursor is first introduced into the reactor (50 ms pulse). Oxygen is introduced continuously in the reactor as well as argon (this silicon precursor does not react with oxygen). After a 2 s purge sequence, a plasma is activated for 4 s. This sequence is followed by a new 2 s purge sequence. The pressure in the reactor is ∼0.2 Pa. These conditions are compatible with a self-limited 1.1 Å/cycle growth.

The Al₂O₃ layer is deposited on the previously deposited SiO₂ layer from trimethylaluminum (TMA) and oxygen plasma. TMA has a high vapor pressure and therefore the vapor is drawn into the reactor. The precursor is introduced into the reactor with a 10 ms duration pulse. Oxygen is introduced continuously in the reactor as well as argon. A first 10 ms TMA pulse is introduced into the reactor followed by a 2 s purge sequence. A plasma is then activated for 4 s and followed by a new 2 s purge sequence. A growth rate of 1 Å/cycle is achieved.

A Si₃N₄ layer is then deposited by PEALD on Al₂O₃ from H₂Si(NEt₂)₂ and NH₃ plasma. The silicon precursor is stored in a stainless steel canister heated at 40°C. The carrier gas is argon. The substrate temperature is regulated at 150°C. The precursor is first introduced into the reactor (0.5s pulse). NH₃ is introduced continuously in the reactor. After a 2s purge sequence, a plasma is activated for 4s. This sequence is followed by a new 2s purge sequence. The pressure in the reactor is ∼10.2 Pa.

This four steps cycle is repeated several times.

A triple stack system Si₃N₄/Al₂O₃/SiO₂ is achieved.

### Deposition of a stack system Si₃N₄/SiO₂ on Si from H₂Si(NEt₂)₂

The SiO₂ layer is deposited on a n-type silicon substrate by PEALD. Oxygen plasma is used as a reactant in combination with H₂Si(NEt₂)₂. The silicon precursor is stored in a stainless steel canister heated at 40°C. The carrier gas is argon. The substrate temperature is regulated at 150°C. The precursor is first introduced into the reactor (50 ms pulse). Oxygen is introduced continuously in the reactor as well as argon (this silicon precursor does not react with oxygen). After a 2 s purge sequence, a plasma is activated for 4 s. This sequence is followed by a new 2 s purge sequence. The pressure in the reactor is ∼0.2 Pa. These conditions are compatible with a self-limited 1.1 Å/cycle growth.

A Si₃N₄ layer is then deposited by PEALD on SiO₂ from H₂Si(NEt₂)₂ and NH₃ plasma. The silicon precursor is stored in a stainless steel canister heated at 40°C. The carrier gas is argon. The substrate temperature is regulated at 150°C. The precursor is first introduced into the reactor (0.5s pulse). NH₃ is introduced continuously in the reactor. After a 2s purge sequence, a plasma is activated for 4s. This sequence is followed by a new 2s purge sequence. The pressure in the reactor is ∼10.2 Pa.

This four steps cycle is repeated several times.

A stack system Si₃N₄/SiO₂ is achieved.

## Claims

1. - A method of forming an Al₂O₃/SiO₂ stack comprising successively the steps of:
a) providing a substrate into a reaction chamber;
b) injecting into the reaction chamber, through an ALD process, at least one silicon containing compound selected from the group consisting of:
| | |
|---|---|
| BDEAS Bis(diethylamino)silane | SiH₂(NEt₂)₂, |
| BDMAS Bis(dimethylamino)silane | SiH₂(NMe₂)₂, |
| BEMAS Bis(ethylmethylamino)silane | SiH₂(NEtMe)₂, |
| DIPAS (Di-isopropylamido)silane | SiH₃(NiPr₂), |
| DTBAS (Di tert-butylamido)silane | SiH₃(NtBu₂); |
c) injecting into the reaction chamber an oxygen source selected in the list: oxygen, ozone, oxygen plasma, water, CO₂ plasma, N₂O plasma;
d) reacting at a temperature comprised between 20°C and 400°C, preferably lower or equal to 250°C, into the reaction chamber at least one of the silicon containing compounds and the oxygen source in order to obtain the SiO₂ layer deposited onto the substrate;
e) injecting on said silicon oxide film, through an ALD process, at least one aluminum containing compound selected in the list: Al(Me)₂(NMe)₂ or Al(Me)₂(NEt)₂;
f) injecting the oxygen source as defined in step c);
g) reacting at a temperature comprised between 20°C and 400°C, preferably lower or equal to 250°C, into the reaction chamber at least one of the aluminium containing compounds and the oxygen source in order to obtain the Al₂O₃ layer deposited onto the SiO₂ layer issued of step d).

2. - A method according to claim 1 wherein said silicon containing compound is BDEAS Bis(diethylamino)silane SiH₂(NEt₂)₂.

3. - A method according to claim 1 or 2, comprising the steps
- Repeating steps b) to d) before the beginning of step e) until the desired SiO₂ layer thickness is obtained; and if necessary,
- Repeating steps e) to g) until the desired Al₂O₃ layer thickness is obtained.

4. - A method according to one of claims 1 to 3, wherein SiO₂ layer has a thickness comprised between 1 nm and 15nm and Al₂O₃ layer has a thickness of 30nm.

5. - A method according to one of claims 1 to 4, comprising the step:
h) annealing the Al₂O₃/SiO₂ stack issued of step g) at a temperature comprised between 400°C and 900°C, preferably between 400°C and 425°C, in an atmosphere of nitrogen.

6. - A method according to claim 5, wherein the duration of the annealing step h) is no more than 10 minutes.

## Patentansprüche

1. Verfahren zum Bilden eines Al₂O_{3/}SiO₂-Stapels, umfassend nacheinander die folgenden Schritte:
a) Bereitstellen eines Substrats in eine Reaktionskammer;
b) Injizieren in die Reaktionskammer, durch einen ALD-Prozess, mindestens einer siliciumhaltigen Verbindung, die ausgewählt ist aus der Gruppe bestehend aus:
BDEAS Bis(diethylamino)silan
SiH₂(NEt₂)₂,
BDMAS Bis(dimethylamino)silan
SiH₂(NMe₂)₂,
BEMAS Bis(ethylmethylamino)silan
SiH₂(NEtMe)₂,
DIPAS (Di-isopropylamido)silan
SiH₃(NiPr₂),
DTBAS (Di tert-butylamido)silan
SiH₃(NtBu₂);
c) Injizieren in die Reaktionskammer einer Sauerstoffquelle, die in der folgenden Liste ausgewählt ist: Sauerstoff, Ozon, Sauerstoffplasma, Wasser, CO₂-Plasma, N₂O-Plasma;
d) Umsetzen bei einer Temperatur zwischen 20 °C und 400 °C, vorzugsweise unter oder gleich 250 °C, in die Reaktionskammer mindestens einer der siliciumhaltigen Verbindungen und der Sauerstoffquelle, um die SiO₂-Schicht zu erhalten, die auf das Substrat abgeschieden wird;
e) Injizieren auf den Siliciumoxidfilm durch einen ALD-Prozess, mindestens einer aluminiumhaltigen Verbindung, die in der folgenden Liste ausgewählt ist:
Al(Me)₂(NMe)₂ oder Al(Me)₂(NEt)₂;
f) Injizieren der Sauerstoffquelle wie in Schritt c) definiert;
g) Umsetzen bei einer Temperatur zwischen 20 °C und 400 °C, vorzugsweise unter oder gleich 250 °C, in die Reaktionskammer mindestens einer der aluminiumhaltigen Verbindungen und der Sauerstoffquelle, um die Al₂O₃-Schicht zu erhalten, die auf die SiO₂-Schicht abgeschieden wird, die aus Schritt d) hervorgeht.

2. Verfahren nach Anspruch 1, wobei die siliciumhaltige Verbindung BDEAS Bis(diethylamino)silan SiH₂(NEt₂)₂ ist.

3. Verfahren nach Anspruch 1 oder 2, umfassend die folgenden Schritte
- Wiederholen der Schritte b) bis d) vor Beginnen mit Schritt e), bis die gewünschte SiO₂-Schichtdicke erhalten wird; und, falls notwendig,
- Wiederholen der Schritte e) bis g), bis die gewünschte Al₂O₃-Schichtdicke erhalten wird.

4. Verfahren nach einem der Ansprüche 1 bis 3, wobei die SiO₂-Schicht eine Dicke zwischen 1 nm und 15 nm aufweist und die Al₂O₃-Schicht eine Dicke von 30 nm aufweist.

5. Verfahren nach einem der Ansprüche 1 bis 4, umfassend den folgenden Schritt:
h) Glühen des Al₂O_{3/}SiO₂-Stapels, der aus Schritt g) hervorgeht, bei einer Temperatur zwischen 400 °C und 900 °C, vorzugsweise zwischen 400 °C und 425 °C, in einer Stickstoffatmosphäre.

6. Verfahren nach Anspruch 5, wobei die Dauer des Glühschrittes h) nicht mehr als 10 Minuten beträgt.

## Revendications

1. Procédé de formation d'un empilement d'Al₂O_{3/}SiO₂ comprenant successivement les étapes de :
a) fourniture d'un substrat à l'intérieur d'une chambre de réaction ;
b) injection à l'intérieur de la chambre de réaction, par un procédé ALD, d'au moins un composé contenant du silicium choisi parmi le groupe constitué de ce qui suit :
| | |
|---|---|
| BDEAS Bis(diéthylamino)silane | SiH₂(NEt₂)₂, |
| BDMAS Bis(diméthylamino)silane | SiH₂(NMe₂)₂ |
| BEMAS Bis(éthylméthylamino)silane | SiH₂(NEtMe)₂, |
| DIPAS (Di-isopropylamino)silane | SiH₃(NiPr₂), |
| DTBAS (Di tert-bytylamino)silane | SiH₃(NtBu₂) ; |
c) injection à l'intérieur de la chambre de réaction d'une source d'oxygène choisie dans la liste : oxygène, ozone, plasma d'oxygène, eau, plasma de CO₂, plasma de N₂O ;
d) réaction à une température comprise entre 20 °C et 400 °C, de préférence inférieure ou égale à 250 °C, à l'intérieur de la chambre de réaction d'au moins l'un des composés contenant du silicium et de la source d'oxygène afin d'obtenir la couche de SiO₂ déposée sur le substrat ;
e) injection sur ledit film d'oxyde de silicium, par un procédé ALD, d'au moins un composé contenant de l'aluminium choisi dans la liste : Al(Me)₂(NMe)₂ ou Al(Me)₂(NEt)2;
f) injection de la source d'oxygène telle que définie à l'étape c) ;
g) réaction à une température comprise entre 20 °C et 400 °C, de préférence inférieure ou égale à 250 °C, à l'intérieur de la chambre de réaction d'au moins l'un des composés contenant de l'aluminium et de la source d'oxygène afin d'obtenir la couche d'Al₂O₃ déposée sur la couche de SiO₂ issue de l'étape d).

2. Procédé selon la revendication 1, dans lequel ledit composé contenant du silicium est le BDEAS Bis(diéthylamino)silane SiH₂(NEt₂)₂.

3. Procédé selon la revendication 1 ou 2, comprenant les étapes de
- répétition des étapes b) à d) avant le début de l'étape e) jusqu'à ce que l'épaisseur de couche de SiO₂ souhaitée soit obtenue ; et si nécessaire,
- répétition des étapes e) à g) jusqu'à ce que l'épaisseur de couche d'Al₂O₃ souhaitée soit obtenue.

4. Procédé selon l'une des revendications 1 à 3, dans lequel la couche de SiO₂ présente une épaisseur comprise entre 1 nm et 15 nm et la couche d'Al₂O₃ présente une épaisseur de 30 nm.

5. Procédé selon l'une des revendications 1 à 4, comprenant l'étape :
h) de recuit de l'empilement d'Al₂O₃/SiO₂ issu de l'étape g) à une température comprise entre 400 O°C et 900 °C, de préférence entre 400 °C et 425 °C, dans une atmosphère d'azote.

6. Procédé selon la revendication 5, dans lequel la durée de l'étape de recuit h) n'est pas de plus de 10 minutes.
